# EUROPEAN PATENT APPLICATION

(11) **EP 4 465 198 A1**
(43) Date of publication of application: **20.11.2024**
(21) Application number: 21818576.7
(22) Date of filing: 30.06.2021
(51) Int. Cl.: G06F 30/20

(54) **ULTRA-REAL-TIME CALCULATION METHOD FOR AXIAL POWER DEVIATION, ELECTRONIC DEVICE, AND STORAGE MEDIUM**

(30) Priority: 03.12.2020 CN 202011396054
(71) Applicant: China Nuclear Power Engineering Co., Ltd., Shenzhen, Guangdong 518124 (CN); China Nuclear Power Design Company Ltd. (Shenzhen), Shenzhen, Guangdong 518100 (CN); China General Nuclear Power Corporation, Shenzhen, Guangdong 518026 (CN); CGN Power Co., Ltd., Shenzhen, Guangdong 518026 (CN)
(72) Inventor: GU, Haixia, Shenzhen, Guangdong 518124 (CN); XIE, Hongyun, Shenzhen, Guangdong 518124 (CN); LI, Jixue, Shenzhen, Guangdong 518124 (CN); DUAN, Qizhi, Shenzhen, Guangdong 518124 (CN); LU, Chao, Shenzhen, Guangdong 518124 (CN)
(74) Representative: Westphal, Mussgnug & Partner, Patentanwälte mbB
(86) International application number: PCT/CN2021/103398
(87) International publication number: WO 2021/244667

(57) **Abstract**

An ultra-real-time calculation method for axial power deviation, an electronic device and a storage medium. The method comprising: setting a boundary condition; determining interface data on the basis of the boundary condition; initializing a simulation reactor core physical model based on the interface data and in combination with real-time data; using the interface data in the simulation reactor core physical model to performing ultra-real-time calculation, and outputting and displaying the result of the ultra-real-time calculation. Using the described method, a trend for a next half-hour may be predicted, and a preview and verification platform that provides an axial power adjustment response scheme in the event of an accident for nuclear power plant operators is able to predict dynamic characteristics of the reactivity of a power plant and the impact on neutron flux distribution during accident conditions relatively accurately, simulating in advance the course of development of various accident conditions, and predicting various risks for a later period, thus allowing the operators more sufficient time to reduce or even eliminate risk.

## Description

### TECHNICAL FIELD

The invention relates to the technical field of axial power deviation of a nuclear power plant reactor core, in particular to an ultra-real-time calculation method for axial power deviation, an electronic device and a storage medium.

### DESCRIPTION OF RELATED ART

With the development of computer technology and the increasing demand of nuclear power, the research and development of ultra-real-time simulation technology has become a new field of nuclear power technology, which can provide operational warning to ensure the safe operation of nuclear power. Nuclear power real-time simulation has been applied in training and engineering verification for many years. Real-time simulation means that the time of simulation model calculation at each time step is less than or equal to the real-time clock, and the simulation results can be displayed to the users of the simulator in real time. Real-time simulation replicates the actual process of the plant in time and appearance, and uses the same "look and feel" of the simulator as the plant. The key feature is replication, which regenerates the plant surface for normal and abnormal operations as well as transient events, and even matches the analysis results for events that did not occur at the plant.

On the basis of real-time simulation, combined with the real-time monitoring data of power plant information system, the research and development of online simulation has been carried out in recent years. The real-time monitoring data is used as the boundary condition of the high-precision model of the real-time simulation, and the synchronous calculation is carried out with the operation state of the power station, so that the real-time monitoring data can be applied to the monitoring of the performance of the power station system or equipment, the expected analysis of the service life of the equipment can be carried out, the real-time monitoring data can also be applied to the playback and analysis of the transient state or abnormal operation of the power station to reduce the future operation errors, and the real-time monitoring data can also be used as the operation suggestion.

Ultra-real-time simulation early warning technology is an extension of online simulation and relates to a series of technical innovations, utilizes field data acquired by a real-time acquisition actual device as an initial state input, obtains a state change trend prediction of a nuclear power plant in the future by accelerating simulation calculation, provides valuable reference information for the operation decision of an operator, and ensures the safe and stable operation of a unit. It is of great practical significance to improve the safety and economy of nuclear power plants.

Axial power deviation is an important safety operating parameter of nuclear power reactor core, which must be operated within its safety range to ensure the integrity of fuel.

The existing online simulation is to calibrate the real-time simulation model with the measured data of the power plant in real time, and the simulation model tracks (and matches) the real working conditions of the power plant within the simulation range. The simulator is connected with the information system of the power station to obtain the measurement data in real time, so as to synchronize with the actual power station and carry out simulation, which is applied to the analysis of power station accidents and the calculation of operational safety limits.

However, the axial power deviation of the existing online simulation scheme can only be equal to the real-time performance of the power station in time, and the trend of the operating parameters related to the axial power deviation is limited according to the statistical method, so the prediction accuracy is limited.

### BRIEF SUMMARY OF THE INVENTION

The technical problem to be solved by the present invention is to provide an ultra-real-time calculation method for axial power deviation, an electronic device and a storage medium, in view of the above defects of the prior art.

The technical scheme adopted by the invention to solve the technical problem is to construct an ultra-real-time calculation method for axial power deviation, which comprises the following steps:
Setting one or more boundary conditions;
Determining interface data according to the boundary condition or conditions;
Initializing a simulation reactor core physical model based on the interface data in combination with real-time data;
And after the simulation reactor core physical model is initialized, using the interface data to performing ultra-real-time calculation in the simulation reactor core physical model.

Wherein, after using the interface data to performing ultra-real-time calculation in the simulation reactor core physical model, the method further comprises:
Outputting and displaying the ultra-real-time calculation result.

Wherein, before setting the boundary condition or conditions, the method comprises:
Obtaining the simulation reactor core physical model.

Wherein the simulation reactor core physical model is established in the following ways:
according to the preset three-dimensional equation and based on a neutron cross section library in the design data of the reactor core, determining the neutron physical characteristics of the reactor core;
Establishing the simulation reactor core physical model by adopting a three-dimensional two-group neutron physical dynamic model and according to the neutron physical characteristics of the reactor core.

Wherein the preset three-dimensional equation is a meshed reactor core diffusion equation in X, Y and Z directions.

Wherein the interface data comprises a physical property parameter of a coolant and a fuel temperature received by a primary loop thermal hydraulic model.

Wherein the initialization of the simulation reactor core physical model based on the interface data and in combination with the real-time data comprises:
Calculating the simulation reactor core physical model based on the coolant physical parameters received by the primary loop thermal hydraulic model and the fuel temperature under the condition of real-time calculation;
Verifying the calculation result with the real-time data after the calculation is completed, and the real-time data comprises neutron range measurements.

Wherein, after the simulation reactor core physical model is initialized, the using the interface data to performing ultra-real-time calculation in the simulation reactor core physical model comprises:
Calculating a shape function in the simulation reactor core physical model by utilize the interface data;
Obtaining reactivity and delayed neutrons according to the shape function;
Calculating an amplitude function based on the reactivity and the delayed neutrons;
Obtaining a neutron flux based on the shape function and the amplitude function;
Obtaining a thermal power of the decay heat and a neutron range based on the neutron flux.

Wherein the obtaining the thermal power of the decay heat and the neutron range based on the neutron flux comprises:
Calculating the thermal power of the decay heat and neutron range based on the neutron flux and a neutron diffusion equation and a six-group delayed neutron balance equation which are time-correlated.

Wherein the method further comprises:
Calculating the concentration of the neutron poison according to the neutron flux;
Updating the neutron cross section data in the neutron cross section library according to the concentration of the neutron poison.

And the concentration of the neutron poison comprises the concentration of xenon and the concentration of samarium.

Wherein the method further comprises:
When using the interface data to performing ultra-real-time calculation in the simulation reactor core physical model:
Carrying out accelerated calculation on the shape function independently according to the multiple of the ultra-real-time simulation, wherein the time step of the ultra-real-time simulation of the shape function is the same as the time step of the real-time simulation.

Wherein the time step of the real-time simulation is 250 milliseconds.

Wherein the method further comprises:
When using the interface data to performing ultra-real-time calculation in the simulation reactor core physical model:
The calculated frequency of the reactivity, the delayed neutron, the amplitude function, and the neutron flux is 4 times/second.

Wherein the method further comprises:
The reactivity, the delayed neutrons, the amplitude function, and the neutron flux are increased by a time step according to a multiple of the ultra real-time simulation.

Wherein the reactor core neutron physical characteristics comprise: any one or more of reactor core neutron physical characteristics of reactor core geometry and fuel configuration normal operation, reactor core neutron physical characteristics of reactor core geometry and fuel configuration expected transient state, and reactor core neutron physical characteristics of reactor core geometry and fuel configuration accident transient state events.

Wherein the boundary conditions comprise control rod positions and reactor core thermal-hydraulic parameters.

The invention also provides a ultra-real-time calculation device for the axial power deviation, which comprises:
a setting module is used for setting boundary condition or conditions;
A determining module is used for determining interface data according to the boundary condition or conditions;
an initialization module is used for initializing a simulation reactor core physical model based on the interface data and in combination with the real-time data;
And an ultra-real-time calculation module is use for using the interface data to performing ultra-real-time calculation in the simulation reactor core physical model after the simulation reactor core physical model is initialized.

The invention also provides an electronic device, which comprises a processor and a memory, wherein the memory is used for storing a computer program, and the processor is used for executing the computer program stored by the memory to realize the ultra-real-time calculation method for axial power deviation.

The invention also provides a storage medium on which a computer program is stored, the computer program, when executed by a processor, implements the steps of the method for ultra-real-time calculation for axial power deviation as described above.

The ultra-real-time calculation method for axial power deviation has the beneficial effects that: setting one or more boundary conditions; determining interface data on the basis of the boundary condition or condition; initializing a simulation reactor core physical model based on the interface data and in combination with real-time data; after the simulation reactor core physical model is initialized, using the interface data to performing ultra-real-time calculation in the simulation reactor core physical model. The method disclose by the invention can be used for predicting the trend of the future half an hour, providing a preview and verification platform of an axial power adjustment response scheme under an accident condition for nuclear power plant operators, can be used for more accurately predicting the reactivity of the power plant under the accident condition and the dynamic characteristics of the influence on neutron flux distribution, simulating the development processes of various accident conditions in advance, and predicting various risks existing in the later period, allowing operators more time to reduce or even eliminate risks.

### BRIEF DESCRIPTION OF THE SEVERAL VIEWS OF THE DRAWINGS

Hereinafter, the present invention will be describe in detail with reference to embodiments with reference to the accompany drawings. In the drawings, like reference numerals are used throughout the various figures to identify identical or functionally similar elements. In addition, the left-most digit of a reference number is used to identify the number of the drawing in which the reference number first appears. In the drawings:
Fig. 1 is a flowchart of an ultra-real-time calculation method for axial power deviation according to an embodiment of the present invention;
Fig. 2 is a calculation flow chart of a simulation reactor core physical model according to an embodiment of the present invention;
Fig. 3 is a schematic structural diagram of an ultra-real-time calculation device for axial power deviation according to an embodiment of the present invention.

### DETAILED DESCRIPTION OF THE INVENTION

For a clearer understanding of the technical features, objects, and effects of the present invention, specific embodiments of the present invention will now be described in detail with reference to the accompanying drawings. A more thorough understanding of the various aspects, advantages, and innovative features of the present invention will be obtained from the following description of the present invention. It is noted that the summary and abstract sections set forth one or more exemplary embodiments, but these are not all embodiments contemplated by the inventors of the present invention.

In order to solve the problems that the simulation axial power deviation at present can only be equal to the real-time performance of a power station basically in time and the prediction accuracy is limited, the invention provides a ultra-real-time calculation method for axial power deviation, the method can predict the future three-dimensional power distribution of the reactor core through ultra-real-time calculation, providing a preview and verification platform for nuclear power plant operators to adjust the axial power in case of accidents. It can accurately predict the dynamic characteristics of nuclear power plant reactivity and the impact on neutron flux distribution under accident conditions simulate the development process of various accident conditions in advance, predict various risks in the later stage, and allow operators more sufficient time to reduce or even eliminate risks.

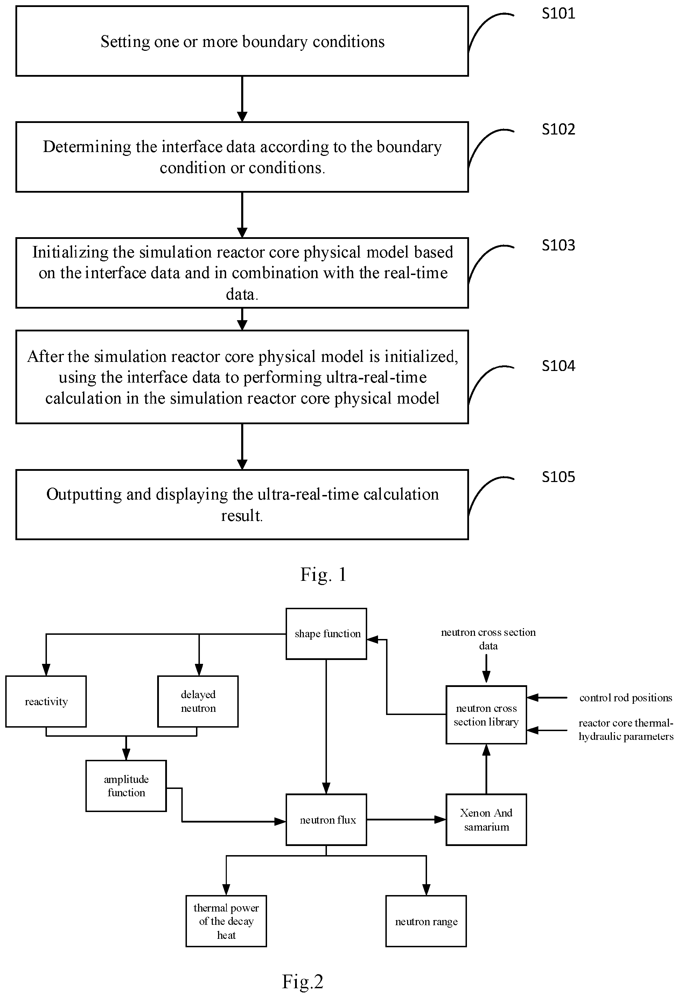

Specifically, referring to fig. 1, fig. 1 is a schematic flow chart of an ultra-real-time calculation method for axial power deviation according to an embodiment of the present invention.

As shown in fig. 1, the ultra-real-time calculation method for axial power deviation comprises:
Step S101, setting one or more boundary conditions.

In some embodiments, the boundary conditions comprise control rod position and core thermal-hydraulic parameters. The core thermal-hydraulic parameters comprise, but are not limited to, moderator temperature, density, and fuel temperature.

Further, in some embodiments, prior to setting the boundary condition or conditions, the method comprises obtaining a simulation reactor core physics model.

The simulation reactor core physical model is established in the following ways:
According to a preset three-dimensional equation and based on a neutron cross section library in the design data of the reactor core, determining the physical characteristics of the reactor core neutrons; and according to the physical characteristic of the reactor core neutrons, establishing the simulation reactor core physical model by utilize a three-dimensional two-group neutron physical dynamics model. Optionally, the preset three-dimensional equation is a meshed reactor core diffusion equation in the X, Y, and Z directions.

In some embodiments, the physical characteristic of the reactor core neutrons comprise any one or more of the physical characteristic of the reactor core neutrons for normal operation of the core geometry and fuel configuration, the physical characteristic of the reactor core neutrons for expected transients of the core geometry and fuel configuration, and the physical characteristic of the reactor core neutrons for accident transients of the core geometry and fuel configuration.

Step S102: Determining the interface data according to the boundary condition or conditions.

Wherein the interface data comprises the coolant physical parameters received by the primary loop thermal hydraulic model and the fuel temperature. Specifically, after the boundary condition or conditions of the simulation are determined, the interface data can be determined according to the set boundary condition or conditions, and the determined interface data is input into the simulation reactor core physical model.

Step S103, initializing the simulation reactor core physical model based on the interface data and in combination with the real-time data.

In some embodiments, initializing the simulation reactor core physical model based on the interface data in combination with the real-time data comprises: under the condition of real-time calculation, the simulation reactor core physical model is calculated by utilize the coolant physical parameter received by the primary loop thermal hydraulic model and fuel temperature; after the calculation is completed, verifying the calculation result by utilize the real-time data; and the real-time data comprises neutron range measurements.

Specifically, under the condition of real-time calculation, the simulation reactor core physical model is calculated by utilize the coolant physical parameter received by the primary loop thermal hydraulic model and fuel temperature, and then the calculation result is verified by utilize the real-time data, so that the purpose of verifying the calculation result of the simulation reactor core physical model is achieved, and the accuracy of the simulation reactor core physical model is ensured.

Optionally, in some embodiments, the coolant physical parameters received by the primary thermal hydraulic model including, but not limited to, temperature, density, void fraction, and boron concentration and so on.

Step S104, after the simulation reactor core physical model is initialized, using the interface data to performing ultra-real-time calculation in the simulation reactor core physical model.

In some embodiments, after the simulation reactor core physics model is initialized, performing a ultra-real-time calculation in the simulation reactor core physics model using the interface data comprises: calculating a shape function in the simulation reactor core physics model using the interface data, obtaining a reactivity and a delayed neutron based on the shape function, calculating an amplitude function based on the reactivity and the delayed neutron, obtaining the neutron flux through the shape function and the amplitude function, obtaining the thermal power of the decay heat and the neutron range according to the neutron flux. The calculation flow chart of the simulation reactor core physical model is shown in Fig. 2.

Specifically, after the initialization of the simulation reactor core physical model is completed, the input interface data is directly called, the shape function is gradually calculated in the simulation reactor core physical model, then the reactivity and the delay neutron are obtained according to the calculated shape function, and then the amplitude function is calculated through the reactivity and the delay neutron. The neutron flux is obtained through the calculated shape function and the amplitude function, and then the thermal power of the decay heat and the change of the neutron energy (namely the neutron range) are calculated according to the obtained neutron energy.

Alternatively, in some embodiments, the thermal power of the decay heat and the change of the neutron flux calculated by the neutron energy can be used to calculate the neutron range and the thermal power of the fission (the thermal power of the decay heat) based on the neutron diffusion equation and the six-group delayed neutron balance equation which are time-correlated.

Further, in some embodiments, after the neutron energy is obtained, the concentration of the neutron poison can be calculated through the neutron, the neutron cross section data in the neutron cross section library can be updated according to the concentration of the neutron poison, and the calculated concentration of the neutron poison can be updated to the neutron cross section data in the neutron cross section library for the next simulation calculation. Alternatively, in some embodiments, the concentration of the neutron poison comprises a concentration of xenon and a concentration of samarium.

Further, in some embodiments, when the ultra-real-time calculation is performed in the simulation reactor core physical model by utilize the interface data, the accelerated calculation of the shape function is performed separately according to the multiple of the ultra-real-time simulation, and the time step of the ultra-real-time simulation of the shape function is the same as the time step of the real-time simulation. Wherein, the time step of the real-time simulation is 250 milliseconds. The calculation frequency of reactivity, delayed neutron, amplitude function and neutron flux is 4 times per second when the interface data is used to carry out ultra-real-time calculation in the simulation reactor core physics model. Wherein the reactivity, the delayed neutrons, the amplitude function, and the neutron flux increase the time step by the multiple of the ultra real-time simulation.

Specifically, when the simulation reactor core model is used for ultra-real-time calculation, the shape function is separately accelerated according to the multiple of the ultra-real-time simulation (wherein, the multiple of the ultra-real-time simulation can be selected and determined according to the actual calculation requirements, for example, it can be 2 times, 3 times, 5 times, etc.), and the same time step of 250 milliseconds as the real-time simulation is maintained. The reactivity, delayed neutron, amplitude function, and neutron energy are kept at a calculation frequency of 4 times per second, and the time step is increased according to the times of the ultra real-time simulation, so that the time prediction of the ultra real-time simulation is realized by 2-10 times.

Further, in some embodiments, after step S104, the method may further comprise:
Step S105: Outputting and displaying the ultra-real-time calculation result.

Specifically, the ultra-real-time calculation results comprise: decay heat power and neutron range. The output and display of the ultra-real-time calculation result can be displayed in a local mode or in a remote mode. For example, the output and display may be performed through a local display terminal, or the output and display may be performed through a remote display terminal for the purpose of convenient viewing.

The ultra-real-time calculation method for axial power deviation disclosed by the embodiment of the invention can predict the trend in the next half hour or more, namely, accelerate the model by 2-10 times or more, and provide a preview and verification platform of the axial power adjustment response scheme under the accident condition for nuclear power plant operators. The dynamic characteristics of the reactivity of the power plant and the influence on the neutron flux distribution under the accident condition can be accurately predicted, the development process of various accident conditions is simulated in advance, various risks existing in the later period are predicted, operators have more sufficient time to reduce or even eliminate the risks, and the accuracy and the instantaneity of the simulation reactor core physical model can be ensured.

It should be understood that while specific configurations and arrangements have been discussed above, this is for illustrative purposes only. Those skilled in the art will appreciate that other configurations and arrangements may be used without departing from the spirit and scope of the present invention. Those skilled in the art will appreciate that the present invention may also be employed in a variety of other applications.

While various embodiments of the invention have been described above, it should be understood that they are for purposes of illustration only and are not intended to be limiting. It will be understood by those skilled in the art that various changes in form and detail may be made therein without departing from the spirit and scope of the invention. Therefore, the scope of the present invention should not be limited to any of the embodiments described above, but should be defined in accordance with the following claims and their equivalents.

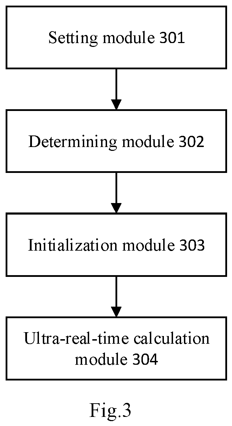

Referring to fig. 3, the present invention further provides an ultra-real-time calculation device for axial power deviation, which can be used to implement the ultra-real-time calculation method for axial power deviation disclosed in the embodiment of the present invention.

Specifically, as shown in fig. 3, the ultra-real-time calculation device for axial power deviation may comprise:
A setting module 301, used for setting one or more boundary conditions.

A determining module 302, used for determining the interface data according to the boundary condition or conditions.

An initialization module 303, used for initializing the simulation reactor core physical model based on the interface data and in combination with the real-time data.

An ultra real-time calculation module 304, used for performing ultra real-time calculation in the simulation reactor core physical model by utilize the interface data after the simulation reactor core physical model is initialized.

The invention also provides an electronic device, which comprises a processor and a memory, wherein the memory is used for storing a computer program, and the processor is used for executing the computer program stored in the memory so as to realize the ultra-real-time calculation method for axial power deviation.

The invention also provides a storage medium on which a computer program is stored, and the computer program is executed by a processor to realize the steps of the ultra-real-time calculation method for axial power deviation.

While the invention has been described with respect to certain embodiments, it will be understood by those skilled in the art that various changes and equivalents may be made to the features and embodiments without departing from the spirit and scope of the invention. In addition, modifications may be made to adapt a particular situation and material to the teachings of the invention without departing from the spirit and scope of the invention. Therefore, the present invention is not limited to the specific embodiments disclosed herein, and all embodiments falling within the scope of the claims of the present application are intended to be within the scope of the present invention.

In this specification, each embodiment is described in a progressive manner, and each embodiment focuses on the differences from other embodiments, and the same and similar parts of each embodiment can be referred to each other. For the device disclosed in the embodiment, since it corresponds to the method disclosed in the embodiment, the description is relatively simple, and the related parts can be described in the method part.

Those skilled in the art will further appreciate that the elements and algorithm steps of the various examples described in connection with the embodiments disclosed herein can be implemented as electronic hardware, computer software, or a combination of both, hi the foregoing description, the components and steps of the various examples have been generally described in terms of function for the purpose of clearly illustrating the interchangeability of hardware and software. Whether these functions are implemented in hardware or software depends on the specific application and design constraints of the technical solution. Skilled artisans may implement the described functionality using different methods for each particular application, but such implementations should not be construed to exceed the scope of the invention.

The steps of a method or algorithm described in connection with the embodiments disclosed herein may be embodied directly in hardware, in a software module executed by a processor, or in a combination of the two. The software module may be placed in a random access memory (RAM), a memory, a read only memory (ROM), an electrically programmable ROM, an electrically erasable programmable ROM, a register, a hard disk, a removable disk, a CD-ROM, or any other form of storage medium known in the art.

One of ordinary skill in the art will appreciate that the term "communication link" as used herein comprises both wireless and wired, direct connections and indirect connections through other elements, components, circuits, or modules. One of ordinary skill in the art will also recognize that inferred coupling (i.e., where one element is inferred to be coupled to another element) comprises wired and wireless, direct and indirect coupling between two elements in the same manner as a "communication coupling".

The invention has been described above with the aid of method steps illustrating specified functions and relationships. For ease of description, the boundaries and order of these functional component modules and method steps are specifically defined herein. However, variations in bounds and order are permissible as long as the given functions and relationships can be properly implemented. The limits or order of any such variations are to be considered within the scope of the claims.

The invention has also been described above with the aid of functional blocks illustrating certain important functions. For ease of description, the boundaries of these functional component modules are specifically defined herein. When these important functions are properly implemented, it is permissible to vary their bounds. Similarly, flowcharting modules have been specifically defined herein to illustrate certain important functions and the boundaries and order of flowcharting modules may be otherwise defined for broad application, as long as these important functions are still implemented. Changes in the boundaries and order of the above functional blocks and the functional blocks of the flowchart should still be considered within the scope of the claims.

Those skilled in the art will also appreciate that the functional blocks described herein, and other illustrative blocks, modules, and components, may be implemented by way of example or in combination of discrete components, special purpose integrated circuits, processors with appropriate software, and the like.

Furthermore, while the details are described for purposes of clarity and understanding of the embodiments described above, the present invention is not limited to these embodiments. Any modification or equivalent substitution of these features and embodiments known to those skilled in the art falls within the scope of the present invention.

The above embodiments are only for illustrating the technical concepts and features of the present invention, and are intended to enable those skilled in the art to understand the contents of the present invention and implement the same, and do not limit the scope of protection of the present invention. All equivalent change and modifications accord to that scope of the appended claims are intended to be including in the scope of the appended claims.

## Claims

1. An ultra-real-time calculation method for axial power deviation, wherein the method comprises the following steps:
setting one or more boundary conditions;
determining interface data according to the boundary condition or conditions;
initializing a simulation reactor core physical model based on the interface data in combination with real-time data;
and after the simulation reactor core physical model is initialized, using the interface data to performing ultra-real-time calculation in the simulation reactor core physical model.

2. The ultra-real time calculation method for axial power deviation according to claim 1, wherein after performing ultra-real time calculation in the simulation reactor core physical model by utilize the interface data, the method further comprises:
outputting and displaying ultra-real-time calculation result.

3. The ultra-real-time calculation method for axial power deviation according to claim 1, wherein before setting the boundary condition or conditions, the method comprises:
obtaining the simulation reactor core physical model.

4. The ultra-real-time calculation method for axial power deviation according to claim 1, wherein the simulation reactor core physical model is established in the following ways:
according to the preset three-dimensional equation and based on a neutron cross section library in the design data of the reactor core, determining the neutron physical characteristics of the reactor core;
and establishing the simulation reactor core physical model by adopting a three-dimensional two-group neutron physical dynamic model and according to the neutron physical characteristics of the reactor core.

5. The ultra-real-time calculation method for axial power deviation according to claim 4, wherein the preset three-dimensional equation is a meshed reactor core diffusion equation in X, Y and Z directions.

6. The ultra-real-time calculation method for axial power deviation according to claim 1, wherein the interface data comprises a coolant physical property parameter received by a primary loop thermal hydraulic model and a fuel temperature.

7. The ultra-real time calculation method for axial power deviation according to claim 6, wherein the initialization of the simulation reactor core physical model based on the interface data and in combination with the real-time data comprises:
calculating the simulation reactor core physical model based on the coolant physical parameters received by the primary loop thermal hydraulic model and the fuel temperature under the condition of real-time calculation;
verifying the calculation result with the real-time data after the calculation is completed, and the real-time data comprises neutron range measurements..

8. The ultra-real-time calculation method for axial power deviation according to claim 1, wherein the using the interface data to performing ultra-real-time calculation in the simulation reactor core physical model after the simulation reactor core physical model is initialized comprises:
calculating a shape function in the simulation reactor core physical model by utilize the interface data;
obtaining reactivity and delayed neutrons according to the shape function;
calculating an amplitude function based on the reactivity and the delayed neutrons;
obtaining a neutron flux based on the shape function and the amplitude function;
and obtaining a thermal power of the decay heat and a neutron range based on the neutron flux.

9. The ultra-real-time calculation method for axial power deviation according to claim 8, wherein the obtaining the thermal power of the decay heat and the neutron range based on the neutron flux comprises:
calculating the thermal power of the decay heat and neutron range based on the neutron flux and a neutron diffusion equation and a six-group delayed neutron balance equation which are time-correlated.

10. The ultra-real-time calculation method for axial power deviation according to claim 8, wherein the method further comprises:
calculating the concentration of the neutron poison according to the neutron flux;
updating the neutron cross section data in the neutron cross section library according to the concentration of the neutron poison.

11. The ultra-real-time calculation method for axial power deviation according to claim 10, wherein the concentration of the neutron poison comprises a concentration of xenon and a concentration of samarium.

12. The ultra-real-time calculation method for axial power deviation according to claim 8, wherein the method further comprises:
When using the interface data to performing ultra-real-time calculation in the simulation reactor core physical model:
carrying out accelerated calculation on the shape function independently according to the multiple of the ultra-real-time simulation, wherein the time step of the ultra-real-time simulation of the shape function is the same as the time step of the real-time simulation.

13. The ultra-real-time calculation method for axial power deviation according to claim 12, wherein the time step of the real-time simulation is 250 milliseconds.

14. The ultra-real-time calculation method for axial power deviation according to claim 12, wherein the method further comprises:
When using the interface data to performing ultra-real-time calculation in the simulation reactor core physical model:
the calculated frequency of the reactivity, the delayed neutron, the amplitude function, and the neutron flux is 4 times/second.

15. The ultra-real-time calculation method for axial power deviation according to claim 14, wherein the method further comprises:
the reactivity, the delayed neutrons, the amplitude function, and the neutron flux are increased by a time step according to a multiple of the ultra real-time simulation.

16. The ultra-real-time calculation method for axial power deviation according to claim 4, wherein
the reactor core neutron physical characteristics comprise: any one or more of reactor core neutron physical characteristics of reactor core geometry and fuel configuration normal operation, reactor core neutron physical characteristics of reactor core geometry and fuel configuration expected transient state, and reactor core neutron physical characteristics of reactor core geometry and fuel configuration accident transient state events.

17. The ultra-real-time calculation method for axial power deviation according to any one of claims 1-16, wherein the boundary conditions comprise control rod positions and reactor core thermal-hydraulic parameters.

18. An ultra-real-time calculation device for axial power deviation, which comprises:
a setting module, used for setting boundary condition or conditions;
a determining module, used for determining interface data according to the boundary condition or conditions;
an initialization module, used for initializing a simulation reactor core physical model based on the interface data and in combination with the real-time data;
and an ultra-real-time calculation module, used for using the interface data to performing ultra-real-time calculation in the simulation reactor core physical model after the simulation reactor core physical model is initialized.

19. An electronic device, wherein the device comprises a processor and a memory, the memory is used for storing a computer program and the processor is used for executing the computer program stored in the memory to realize the ultra-real-time calculation method for axial power deviation according to any one of claims 1-17.

20. A storage medium, on which a computer program is stored, wherein the computer program, when executed by a processor, implements the steps of the method for ultra-real-time calculation for axial power deviation according to any one of claims 1-17.
